# EUROPEAN PATENT APPLICATION

(11) **EP 2 487 731 A1**
(43) Date of publication of application: **15.08.2012**
(21) Application number: 11305136.1
(22) Date of filing: 10.02.2011
(51) Int. Cl.: H01L 39/16

(54) **Composite with coated conductor**

(71) Applicant: Nexans, 75008 Paris (FR)
(72) Inventor: Krämer, Simon, 50321 Brühl (DE); Bludau, Markus, 53374 Erftstadt (DE)
(74) Representative: Feray, Valérie

(57) **Abstract**

A high-temperature superconductor composite (1) comprising at least one coated conductor (2) and an electrically insulating material (3) is disclosed, wherein the at least one coated conductor (2) is arranged onto or embedded within the electrically insulating material (3) and wherein the high-temperature superconductor composite (1) is suitable as a standardized, modular prefabricated component in the production of high-temperature superconductor devices such as a fault current limiter.

## Description

The present invention relates to the field of high-temperature superconductor (hts) coated conductors. In particulars the present invention relates to a composite with a coated conductor suitable as a prefabricated hts component, for example in a fault current limiter.

Coated conductors, which are also referred to as "second generation superconductors", typically have a long length as required for example in the production of cables and wires.

They are composed of a multilayer structure with a substrate, a superconductor layer and at least one buffer layer between the substrate and the hts-layer. The buffer layer(s) serve to compensate for the various different properties of the materials used. For example, buffer layer(s) can be provided for preventing poisoning of the hts-layer by constitutional elements of the substrate which might diffuse toward the hts-layer. According to need one or more further layers can be provided. For example, a metal protection layer can be deposited onto the hts-layer.

Superconductor materials are characterized in that they have zero resistance when operated below a certain temperature (the critical temperature Tc) and external magnetic field (the critical magnetic field Hc) if the current flowing through the superconductor material is below a certain threshold value (critical current Ic).

The critical current, critical temperature and critical magnetic field are specific for a given superconductor material. However, if any of these parameters is exceeded, the superconductor material suddenly loses its superconducting properties and behaves like a "normal" resistor, it is said the material quenches.

Superconductors having a Tc above the temperature of 30 K are generally referred to as high-temperature superconductors. Particularly preferred high-temperature superconductors are those having a Tc greater than the boiling point of liquid nitrogen (77 K or -196 °C) which allows cooling with liquid nitrogen, a cheap and easily available cooling medium.

Examples of high-temperature superconductors with a critical temperature above 77 K are those known as ceramic oxide high-temperature superconductors, such as those based on rare earth metal (RE inclusive Y), Bi, TI and Hg.

Though not restricted thereto, in the production of coated conductors currently the rare earth barium cuprate-type superconductors of the formula REBa₂Cu₃O₇-ₓ are conventionally used, with x representing the oxygen content in the range appropriate for the particular superconductor material. RE means at least one rare-earth element, particularly Y or a combination of two or more of the elements Y, La, Lu, Sc, Sm, Nd or Yb. A preferred member thereof is that one known by the reference YBCO-123 wherein the numerical combination 123 stands for the stoichiometric ratio of the elements Y, Ba and Cu.

Coated conductors are promising candidates for a plurality of electrical applications such as high and medium voltage power transmission cables, wire applications, transformers, magnets (for example, for magnetic resonance imaging), synchronous motors with superconducting windings and fault current limiters.

For example, superconductor fault current limiters are devices that automatically limit fault current in high-voltage networks to a low current value close to the nominal current. The benefit of such a device is that it reduces drastically the short circuit power of the high-voltage network and, thus, allows to interconnect networks without increasing the short circuit power or to decrease safety margins so that other machineries connected to the network can be designed for lower short short circuit power and, therefore, can be made lighter and cheaper.

Superconductor fault current limiters make use of the property of superconductor material to have virtually no electrically resistance when operated below the critical temperature-even at nominal power loads. However, if the critical current (above the nominal current) is exceeded, the material suddenly loses its superconducting properties and behaves like a "normal" resistor. This relatively high resistance limits the current to a pre-defined value. In many applications, such as in fault current limiters, a long length of coated conductor is required and need winding of the coated conductor. However, there is a number of problems associated with the winding of a long length of coated conductor for obtaining, for example, a practically useful switching module for a fault current limiter.

The winding should be spatially compact for allowing space saving accommodation. However, due to the brittleness inherent to ceramic material such as the superconductors and the buffer layers used in coated conductors, these materials are liable to damage on mechanical stress. This means a limitation of the possible bending radius which must not be too small. Currently, typical bending radii are in a range of 20 to 50 mm.

Efficient cooling of the superconductor components is necessary. To this, the coated conductor should be preferably in direct contact with the cooling medium. For example, in a fault current limiter when a fault current occurs and the superconductor becomes resistive, the superconductor is heated up to a temperature of 300 K or more in the course of quench. For the fault current limiter to be ready for use again rapid cooling back to the operational temperature is therefore necessary.

Considering, that fault current limiters should be used at high-voltage levels in a range of between 10 kV to above 100 kV, typically, a very long length of coated conductor is needed. Otherwise, the fault current limiter which is to be interconnected into an electrical application should be as small as possible to save space. Thus, there is a need, to place a long length of coated conductor within the cryostat housing with minimum space requirements to keep the overall cryostat housing as small as possible.

Summarizing a coated conductor to be suitable for practical use in particular in a fault current limiter, must met a plurality of sometimes conflicting requirements:
In view of space saving a compact winding on the coated conductor is desired on one side. However, for avoiding mechanical damage of the tape the bending radius must be properly selected. In view of cooling the design should allow direct contact of the cooling medium with the high-temperature superconductor layer to allow fast re-cooling to operation temperature after quench.
In view of dielectric strength the design should allow sufficient distance between locations of high potential difference for avoiding partial discharge and flash over.
In view of easy and cost effective adaption to the specific operation conditions of specific electric applications a modular design of the coated conductor components is desired for allowing standardization and simple adjustment to various constructions and operation conditions.

The hts material should have a configuration with an inductance as small as possible. Inductance generates fields causing high Lorentz forces which exert mechanical stress on the hts component. Moreover, increasing fields lead to a significant decrease of the current carrying capacity of the hts material.

According to the present invention these and other problems are solved by a composite wherein a coated conductor is applied onto an electrically insulating material.

According to a further aspect the present invention provides a composite wherein a coated conductor is embedded within an electrically insulating material.

According to yet another aspect the electrically insulating material is preferably a prepreg.

The present invention provides a composite wherein a coated conductor is arranged onto or embedded into an electrically insulating material.

Typically, a coated conductor is a tape shaped article of long length, which means that the longitudinal extension significantly exceeds the width or diameter. Thus, in the following reference is made also to a "coated conductor tape" or "tape-shaped coated conductor".

The tape-shaped coated conductor can have an essentially rectangular or essentially round cross-sectional shape. "Essentially rectangular" or "essentially round" means that the cross-sectional shape may deviate from an ideal rectangular or round shape, for example being trapezoid or oval. It is also possible to use a coated conductor wherein the substrate is coated on both sides with a hts-layer and buffer layer(s). Further, in case of an essentially round coated conductor, typically the layers and the substrate are coaxially arranged onto the substrate.

Coated conductors, their configuration and production methods thereof are well known in the art.

According to the present invention one or more tape-shaped coated conductor can be arranged onto or into the insulating material. The individual coated conductors arranged onto or into the insulating material can be connected electrically in parallel and/or in series.

The composite of the present invention provides a coated conductor component which can be pre-fabricated and allows modular and standardisized configuration. For example, in a composite a number of m tape-shaped coated conductor can be arranged onto an insulating material and connected electrically in parallel. In the result, the available length of coated conductor can be easily varied by varying the number of composites electrically connected in series. Depending on the operation parameters for a fault current limiter the required number of I of such individual composites can be placed within the cryostat and connected electrically in series for obtaining a desired length of coated conductor.

By connecting individual coated conductors and/or composites electrically in parallel the current-carrying cross-sectional area of the coated conductor can be enhanced.

The number of coated conductors of an individual composite can be varied according to need and particular dimension of the individual composite.

The insulating material bearing or having embedded the coated conductor can have any suitable shape. For example, shapes are possible having surface area which is rectangular, polygonal, round, elliptical etc. Examples thereof is a plate, strip or disc.

The electrical insulating material can be any such material conventionally used in the production of high-temperature superconductor devices such as hts fault current limiters and cables.

However, contrary to the known applications according to the present invention the insulating material is used in a pre-fabricated product, such as a fault current limiter component, which is ready to be mounted in a hts device, such as a fault current limiter.

Suitable examples of such insulating materials are cold resistant plastics, epoxy resin etc.

According to an preferred embodiment the electrically insulating material is a prepreg. Prepregs as such are also well known. For the present invention any commercially available prepreg can be used.

Prepregs are semi-finished articles and are composed of fiber-reinforced plastics which are impregnated with a non-hardened resin. After arranging the coated conductor onto or into the prepreg hardening is carried out by heating to a suitable temperature, for example about 100 °C.

Examples of prepregs which can be used are those, wherein glass, aramide, carbon or graphite fibers are impregnated with epoxy-, polyester-, or phenole resins.

For appropriate superconducting performance the high temperature superconductor layer of a coated conductor must have a high degree of crystallographic orientation to allow the current to be transferred across the crystallites. The individual crystallites of the layer should be tilted against one another only by a minimum value, since otherwise superconducting properties are severely impaired.

Currently, there are two main approaches to achieve the desired high crystal orientation. According to the first approach a highly-textured buffer layer is deposited onto a polycrystalline, randomly oriented substrate by direct physical coating processes such as ion beam assisted deposition (IBAD) and inclined substrate deposition (ISD). The highly textured buffer layer serves to transfer the desired texture to the superconductor layer grown onto the buffer layer. According to the second approach a highly-textured substrate is used which can be obtained by mechanical working, for example by RABiTS (rolling assisted biaxial texturing of substrates). Here the texture of the substrate is transferred to the buffer layer, and, then, to the superconductor layer deposited thereon. Examples of metals suitable as substrate are copper, nickel, silver, iron and alloys thereof.

Suitable buffer layer materials are lanthanum-zirconate, cerium oxide, yttrium-stabilized zirconia (YSZ), gadolinium-zirconate, yttrium oxide, rare earth aluminates such as lanthanum-aluminate, strontiumtitanate, nickel oxide, magnesium oxide, oxides of general formular RE₂A₂O₇ with RE as defined above and A being selected from Zr and Hf, in particular La₂Zr₂O₇ (LZO, lanthanum-zirconate) and many others.

Preferably, the high-temperature superconductor is a ceramic oxide high temperature superconductor selected from the group consisting of bismuth-based, thallium-based, rare earth metal based, and mercury-based superconductor ceramic oxides.

Typical examples thereof comprise ceramic oxide superconductors based on Bi-Ae-Cu-Oy, (Bi, Pb)-Ae-Cu-O_{y}, Re-Ae-Cu-O_{y}, TI-Ae-Cu-O_{y} or Hg-Ae-Cu-O_{y} wherein y represents the relative oxygen content in the range appropriate for the particular superconductor material to have superconducting property.

In the above formula Ae means at least one alkaline earth element, particularly, Ba, Ca and/or Sr. RE is as defined as above with respect to the REBa₂Cu₃O₇₋ₓ material. Preferably the high temperature superconductor ceramic oxide is of the type RE-Ae-Cu₃-O₇₋ₓ with Re, Ae and x being defined as above.

More preferably the high-temperature superconductor ceramic oxide is type RE, Ba₂Cu₃O₇₋ₓ with RE and x being defined as above. More preferably the high-temperature superconductor ceramic oxide is of type YBCO-123.

Multiple deposition processes are known for obtaining the hts layer and buffer layers for a coated conductor.

Examples for suitable deposition techniques of the hts layer as well as of buffer layers, for example those referred to above are pulsed laser deposition, thermal co-evaporation, chemical vapor deposition, chemical solution deposition, such as metal organic deposition, sol gel methods and many others.

The present invention is now explained in more detail by reference to the accompanying drawings. These drawings are of illustrative nature only and do not mean any restriction of the present invention.

It is shown in
- figure 1: a longitudinal section through a first embodiment of the composite of the present invention,
- figure 2: a longitudinal section through a second embodiment of the composite of the present invention,
- figure 3: a further embodiment of the composite of the present invention with a plurality of tape-shaped coated conductor connected electrically in parallel,
- **figure 4**: a further configuration of the embodiment shown in figure 3 with the tape-shaped coated conductor being connected electrically in series,
- **figure 5**: an example for a configuration of the composite of the present invention,
- **figure 6**: a plan view onto a cross-section through a cryostat with a composite of the present invention arranged therein, and
- **figure 7**: a longitudinal section through the cryostat shown in figure 4.

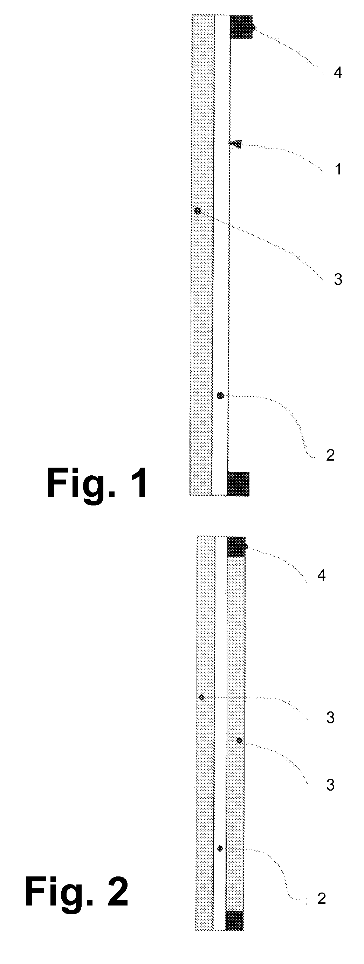

In the embodiment of **figure 1** a composite 1 of the present invention is shown wherein a tape-shaped coated conductor 2 is attached onto a support 3 made of electrically insulating material (also referred to "insulating support") At each end of the tape-shaped coated conductor 2 an electrical contact 4 is provided for connecting the tape-shaped coated conductor 2 electrically with the surrounding.

In the embodiment shown in figure 1 the tape-shaped coated conductor 2 extends over the whole longitudinal extension of the insulating support 3.

However, there is no particular restriction to a whole extension of the coated conductor tape 2 across the whole insulating support 3. According to need the coated conductor tape 2 can be shorter, that is, extend only over a part of the longitudinal or lateral extension of the insulating support 3.

If necessary, an adhesive - as known for superconductor applications - can be used for attaching the coated conductor 2 to the electrically insulating material 3.

The electrical contact 4 can be made of any suitable material, for example a metal or a superconducting material. Suitable materials are well known in the art. Typical metals are noble metals such as gold, silver, copper and alloys of these metals. In view of costs copper is widely used currently.

In this embodiment the coated conductor has a "free" surface, that is a surface not covered with the insulating material. Such a free surface is particularly suitable for cooling since it allows direct contact with the cooling medium.

A longitudinal section through a further embodiment of the composite 1 of the present invention is shown in figure 2. In this embodiment the tape-shaped coated conductor tape 2 is embedded within the electrically insulating material 3 with electrical contacts 4 provided at each end of the coated conductor tape 2 for electrically connecting the coated conductor tape 2 of the composite 1 with the surrounding.

In the embodiment shown in figure 2 both contacts 4 are provided on the upper side of the coated conductor tape 2.

However, it is also possible to provide both contacts 4 on the bottom side of the coated conductor tape 2 or one at the upper and the other at the lower side, whatever position of the contacts 4 is more suitable.

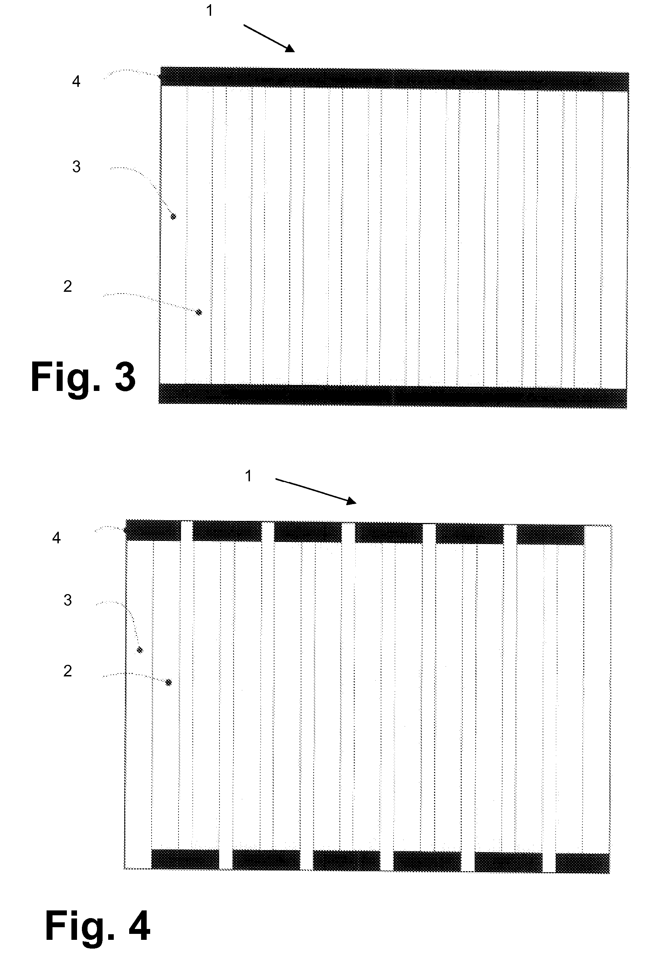

**Figure 3** shows a plan view of a further embodiment of the composite 1 of the present invention.

In the embodiment shown in figure 2 a plurality of tape-shaped coated conductor 2 is arranged side by side and in parallel onto an electrically insulating support 3.

Electrically contacts 4 are provided on each end of the coated conductor tapes 2, wherein the electrical contact 4 extends over all the ends of each side of all coated conductor tapes 2 for connecting the individual coated conductor tapes 2 electrically in parallel.

In **figure 4** a plan view of a composite 1 is shown having the same arrangement of coated conductor tapes 2 onto an insulating support 3 as in figure 3. However, in this embodiment the individual coated conductor tapes 2 are connected electrically in series. For serial connection the electrical contacts 4 are alternately connected to adjacent ends of adjacent coated conductor tapes 2 to form a meander. At the entry 7 and the exit 8 the free end of a single coated conductor tape 2 is provided with a further electrical contact for connecting the composite with the surrounding.

The overall composite can have a cylinder shape as shown in figure 4 with electrical contacts 4 at the upper and lower end of the cylinder.

The coated conductor tapes (not shown in the figure) can be provided either onto the outer or inner surface or onto both surfaces of the cylinder. The tape-shaped coated conductors can be vertically or horizontally arranged. It is also possible to arrange the tape-shaped coated conductors within the cylindrical insulating material; i.e. embedding therein.

Such a configuration of the composite 1 of the present invention can be suitably used as a component for a fault current limiter.

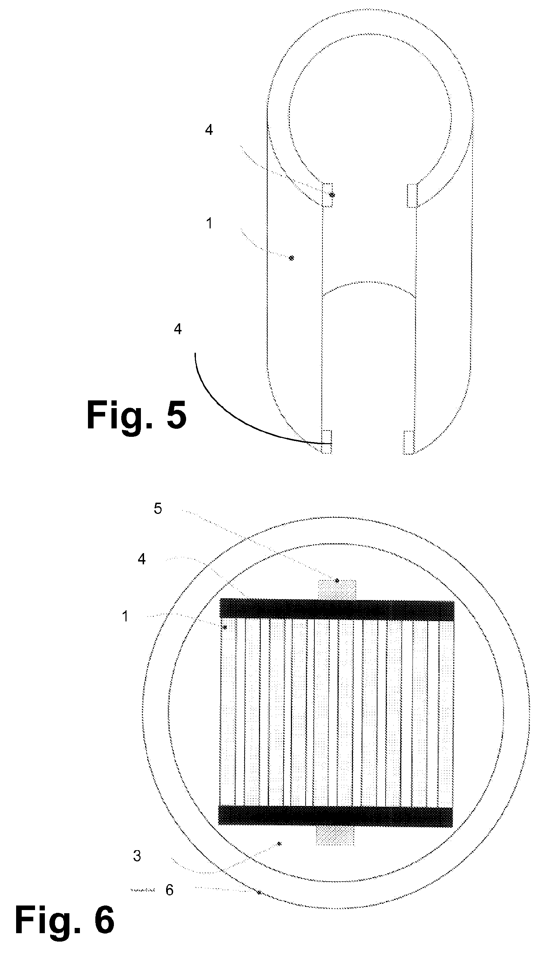

Since, for example, typically the cold bore of the cryostat of a superconductor fault current limiter has also a cylinder form the configuration of the composite of figure 5 can be easily mounted within the cryostat.

Two or more of such cylindrical composites can be mounted within the cryostat. For example, a coaxial arrangement is possible with cylindrical composites of decreasing diameter.

A further configuration of the composite 1 of the present invention is shown in figure 6. Shown is a composite 1 with disc shaped insulating support 3 and a plurality of coated conductor tapes 2 arranged in parallel and side by side onto a plan face of the disc-shaped insulating support 2.

The disc shaped composite 1 can be placed into the cold bore of a cryostat 6. The round disc shaped composite 1 can be easily mounted within the interior of the cryostat 6 having typically also a round cross-sectional area.

In the embodiment shown in figure 6 the plurality of coated conductor tapes 2 is connected electrically in parallel via the electrical contacts 4 provided at each end side of the coated conductor tapes 2 and covering all ends of the coated conductor tapes 2 at the respective side.

The electrical contacts 4 are each connected to an electrical connection 5 for electrically connecting the coated conductor tapes 2 onto the composite 1 with the surrounding.

For example, via electrical connections 5 the composite 1 can be electrically connected to further composites 1 additionally mounted within the cryostat.

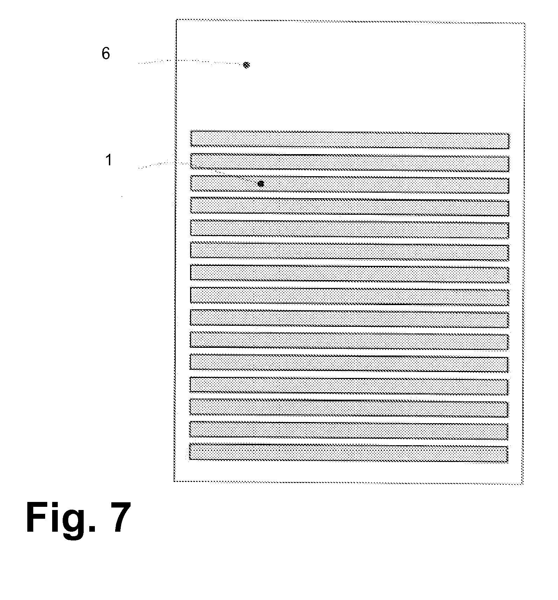

A longitudinal section through an arrangement of a plurality of composites 1 arranged within a cryostat 6 is schematically shown in figure 7. In this embodiment a plurality of composite plates 1 is mounted within a cryostat 6 one above the other to form a stack of composite plates 1.

It is also possible to mount a plurality of composites 1 in vertical direction one of the other - into a cryostat.

Reduction of inductance is possible by providing a configuration which allows changing direction of the current flow. An example for such a configuration is that shown in figure 4 wherein direction of current flow in adjacent coated conductors 2 is opposite to each other.

It is also possible to connect two or more composites electrically in series in a manner that the flow direction of the current in consecutively arranged composites 1 is opposite to each other.

According to need the composites 2 can be connected electrically in series to enhance the length of current path available; they can be connected electrically in parallel for increasing the available current carrying cross section for allowing a higher nominal current. Also a combination of parallel and serial electrical connection is possible.

Considering a support 3 such as plate with an upper and lower surface, one or more coated conductor tapes 2 can be arranged onto at least one surface of the support 3.

The coated conductor tapes 2 arranged onto at least one surface of a support 3 can be electrically connected in parallel and/or in series.

Preferably, the coated conductor tapes 2, arranged onto a surface of a support 3, are arranged side by side and in parallel.

According to need, between the tape-shaped coated conductor and the layer of electrically insulating material an adhesion promoter can be provided. Such adhesion promoter serves for compensating different thermal expansion of the electrically insulating material 3 and the coated conductor 2.

The composite 1 of the present invention can be suitably used as a pre-fabricated module for superconducting applications and allows a high degree of standardisized production as well as modular configuration of the composites. By varying the number of composites and/or number of coated conductors of an individual composite 1 easy scaling up or down is possible. Moreover, the modular and standardized design of the composites of the present invention allows a compact and space saving layout within a container with only limited space such as in a cryostat.

Depending on the operation conditions of a superconducting application a suitable number of prefabricated composites can be used.

For example, the composites of the present invention can be suitably used as prefabricated modular components such as a switching module for a fault current limiter, in particular a resistive fault current limiter.

The composites can be easily mounted within a cryostat of a fault current limiter and allows simple adaption of a fault current limiter to the nominal current and nominal voltage level of the specific electrical application, for example power network which should be protected by the fault current limiter against high-fault currents.

### list of reference numbers

- 1: composite
- 2: coated conductor
- 3: electrically insulating material
- 4: electrical contact
- 5: electrical connection
- 6: cryostat

## Claims

1. A high-temperature superconductor componsite (1) comprising at least one coated conductor (2) and an electrically insulating material (3) wherein the at least one coated conductor (2) is arranged onto or embedded within said electrically insulating material (3).

2. High-temperature superconductor composite according to claim 1,
wherein the electrically insulating material (3) has a shape with a surface area which is essentially rectangular or round.

3. High-temperature superconductor composite according to claim 1 or 2, wherein the electrically insulating material (3) has the shape of a plate or a disc.

4. High-temperature superconductor composite according to any of the preceding claims,
wherein the electrically insulating material (3) is a prepreg.

5. High-temperature superconductor composite according to any of the preceding claims, with two or more coated conductors (2),
wherein the individual coated conductors (2) are connected electrically in series.

6. High-temperature superconductor composite according to any of claims 1 to 4, with two or more coated conductors (2) wherein the individual coated conductors (2) are connected electrically in parallel.

7. High-temperature superconductor composite according to any of the preceding claims,
wherein the high-temperature superconductor composite (1) is a prefabricated component ready to be used in the production of a high-temperature device.

8. High-temperature superconductor composite according to claim 7,
wherein the high-temperature superconductor composite (1) is a switching module for a high-temperature superconductor fault current limiter.

9. High-temperature superconductor composite according to any of the preceeding claims,
wherein the composite (1) has a cylindrical shape.

10. High-temperature superconductor fault current limiter comprising at least one of the prefabricated composite (1) according to any of the claims 1 to 9.

11. High-temperature superconductor fault current limiter according to claim 10, comprising at least 2 high-temperature superconductor composites (1) of cylindrical shape, wherein the individual high-temperature superconductor composites (1) of cylindrical shape are different in diameter and are arranged coaxially one into the other.

12. High-temperature superconductor fault current limiter comprising at least two high-temperature superconductor composites (1),
wherein the individual high-temperature superconductor composites (1) are connected electrically in series via electrical connection (5).

13. High-temperature superconductor fault current limiter comprising at least two high-temperature superconductor composites (1),
wherein the high-temperature superconductor composites are connected electrically in parallel via electrical connection (5).

14. Use of a high-temperature superconductor composite (1) according to any of the claims 1 to 9 as a prefabricated component in the production of a high-temperature superconductor device.

15. Use of a high temperature superconductor composite (1) according to any of the claims 1 to 9 as a switching module in a high temperature superconductor fault current limiter.

## Amended claims

### Amended claims in accordance with Rule 137(2) EPC.

**1.** A high-temperature superconductor composite (1) comprising two or more coated conductors (2) and an electrically insulating material (3) wherein the two or more individual coated conductors (2) are arranged onto or embedded within said electrically insulating material (3), and are connected electrically in series and/or in parallel.

**2.** High-temperature superconductor composite according to claim 1,
wherein the electrically insulating material (3) has a shape with a surface area which is essentially rectangular or round.

**3.** High-temperature superconductor composite according to claim 1 or 2,
wherein the electrically insulating material (3) has the shape of a plate or a disc.

**4.** High-temperature superconductor composite according to any of the preceding claims,
wherein the electrically insulating material (3) is a prepreg.

**5.** High-temperature superconductor composite according to any of the preceding claims,
wherein the high-temperature superconductor composite (1) is a prefabricated component ready to be used in the production of a high-temperature device.

**6.** High-temperature superconductor composite according to claim 5,
wherein the high-temperature superconductor composite (1) is a switching module for a high-temperature superconductor fault current limiter.

**7.** High-temperature superconductor composite according to any of the preceeding claims,
wherein the composite (1) has a cylindrical shape.

**8.** High-temperature superconductor fault current limiter comprising at least one of the prefabricated composite (1) according to any of the claims 1 to 7.

**9.** High-temperature superconductor fault current limiter according to claim 8, comprising at least 2 high-temperature superconductor composites (1) of cylindrical shape, wherein the individual high-temperature superconductor composites (1) of cylindrical shape are different in diameter and are arranged coaxially one into the other.

**10.** High-temperature superconductor fault current limiter according to any of the claims 8 or 9, comprising at least two high-temperature superconductor composites (1),
wherein the individual high-temperature superconductor composites (1) are connected electrically in series via electrical connection (5).

**11.** High-temperature superconductor fault current limiter according to any of the claims 8 to 10 comprising at least two high-temperature superconductor composites (1),
wherein the high-temperature superconductor composites are connected electrically in parallel via electrical connection (5).

**12.** Use of a high-temperature superconductor composite (1) according to any of the claims 1 to 7 as a prefabricated component in the production of a high-temperature superconductor device.

**13.** Use of a high temperature superconductor composite (1) according to any of the claims 1 to 7 as a switching module in a high temperature superconductor fault current limiter.
